# EUROPEAN PATENT APPLICATION

(11) **EP 4 001 903 A1**
(43) Date of publication of application: **25.05.2022**
(21) Application number: 20208709.4
(22) Date of filing: 19.11.2020
(51) Int. Cl.: G01N 21/956, H01J 37/244, H01J 37/28

(54) **INSPECTION METHOD AND INSPECTION TOOL**

(71) Applicant: ASML Netherlands B.V., 5500 AH Veldhoven (NL)
(72) Inventor: SCOTUZZI, Marijke, 5500 AH Veldhoven (NL); VEENSTRA, Roy, Ramon, 5500 AH Veldhoven (NL); KIERS, Antoine, Gaston, Marie, 5500 AH Veldhoven (NL)
(74) Representative: ASML Netherlands B.V.

(57) **Abstract**

Disclosed herein is an inspection tool and a method for identifying defects in a sample. The method includes steps of scanning a first area of a sample with a first detector-beam and scanning a second area of the sample with a second detector-beam, then receiving first and second signals that are derived from the first and second detector-beams. The first and second signals are compared to determine whether a defect is present in the sample.

## Description

### FIELD

The embodiments provided herein generally relate to the data processing in an inspection tool, for example a charged particle beam inspection apparatus. Embodiments also provide an inspection method and an inspection tool.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the target. By scanning the primary electron beam as the probing spot over the target surface, secondary electrons can be emitted across the surface of the target. By collecting these emitted secondary electrons from the target surface, a pattern inspection tool may obtain an image-like signal representing characteristics of the material structure of the surface of the target. In such inspection the collected secondary electrons are detected by a detector within the tool. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection tool has a single beam and may be referred to as a Single Beam SEM. There have been attempts to introduce a multi-electron beam inspection in a tool (or a 'multi-beam tool') which may be referred to as Multi Beam SEM (MBSEM).

Another application for an electron-optical column is lithography. The charged particle beam reacts with a resist layer on the surface of a substrate. A desired pattern in the resist can be created by controlling the locations on the resist layer that the charged particle beam is directed towards.

An electron-optical column may be an apparatus for generating, illuminating, projecting and/or detecting one or more beams of charged particles. The path of the beam of charged particles is controlled by electromagnetic fields. Stray electromagnetic fields can undesirably divert the beam.

Physical defect or pattern inspection of samples may also be carried out by using brightfield optical inspection using an optical inspection tool or electron beam inspection. Such a tool is used to generate an image from inspecting a sample, except light is used. The light (i.e. photons) from an incidental light beam is scattered from the sample. As for electron-beam inspection a detector detects the scattered photons. The detection signal data which is transmitted to processor to generate an image of pixels.

Bright field inspection suffers from low spatial resolution, while single beam inspection tends to suffer from low throughput. Multi-electron beam inspection is a high throughput and high resolution instrument that allows the detection of defects of sizes smaller than 10nm. Together such bright field inspection tools and multi-electron beam tools may be referred to as 'multi detector-beam tools' .

However, the storage and the processing of the data acquired by the multi-beam tool to generate images entails large datapath load, in terms not only in terms of the amount of processing e.g. the number of CPUs but also in time. The number of pixels, that have to be generated from the collected data in a high volume multi-beam tool is very high and therefore the time taken for this analysis causes delays in the inspection process. The data used to generate pixels has to be sent from the detector within the tool to a computer rack remote from the detector either within the tool (but away from the optical or electron optics) or external to the tool and analyzed for defects. With time there are increasing demands for quantity and quality of inspection data especially in view of the required improvements in resolution. This arrangement for obtaining information on defect analysis from the detection signal within the inspection tool becomes increasingly complex, time consuming (i.e. undesirably slow) and expensive.

### SUMMARY

According to a first aspect of the invention, there is provided an inspection tool for identifying defects in a sample, comprising: a first beam generation device configured to generate a first detector-beam along a first detector-beam path to scan a first area of a sample; a second beam generation device configured to generate a second detector-beam along a first detector-beam path to scan a second area of the sample; a first detector configured to generate a first signal based on the scan of the first area by the first detector-beam; a second detector configured to generate a second signal based on the scan of the second area by the second detector-beam; and a comparison unit configured to compare the first and second signals and to determine whether a defect is present in the sample.

According to another aspect of the invention, there is provided an inspection method for identifying defects in a sample, the method comprising: scanning a first area of a sample with a first detector-beam and scanning a second area of the sample with a second detector-beam; receiving first and second signals that are derived from the first and second detector-beams; comparing the first and second signals; and determining whether a defect is present in the sample.

According to another aspect of the invention, there is provided an electron-optical tool configured to project a plurality of multi-electron beams towards a sample, the tool configured to identify defects in a sample, comprising: electron-optical columns configured to project corresponding multi-electron beams towards a sample; detector arrays configured corresponding to respective electron-optical columns and configured to generate respective signals on detection of secondary electrons generated by interaction of the respective multi-electron beams with the sample; and a comparator configured to compare signals generated in the detector arrays and to determine whether a defect is present in the sample.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary charged particle beam inspection apparatus.
Figure 2 is a schematic diagram illustrating an exemplary multi-beam electron-optical column that is part of the exemplary inspection apparatus of Figure 1.
Figure 3 is a schematic diagram of an exemplary electron-optical system comprising a collimator element array and a scan-deflector array that is part of the exemplary inspection apparatus of Figure 1.
Figure 4 is a schematic diagram of an exemplary electron-optical system array comprising the electron optical systems of Figure 3.
Figure 5 is a flow chart illustrating an overview of an inspection method.
Figure 6 is a schematic diagram illustrating a sample with no defects, which has been scanned by four detector-beams generated by different beam generation devices, and the corresponding signals based on the scans.
Figure 7 is a schematic diagram illustrating a sample with a missing hole type defect, which has been scanned by four beam generation devices, and the corresponding signals based on the scans.
Figure 8 is a schematic diagram illustrating a sample with unwanted particle type defects, which has been scanned by four beam generation devices, and the corresponding signals based on the scans.
Figure 9 is a schematic diagram illustrating an inspection tool comprising three beam generation devices scanning features of a sample with detector-beams.
Figure 10 is a schematic diagram illustrating an inspection tool comprising three columns scanning a sample.
Figure 11 is a flow chart illustrating an overview of a die-to-die wafer inspection using a three column inspection tool.
Figure 12 is a schematic diagram illustrating a sample with a two column inspection tool, identifying different scan areas.
Figure 13 is a schematic diagram illustrating a sample with a three column inspection tool, identifying different scan areas.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### BRIEF DESCRIPTION OF FIGURES

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection tools (such as a Scanning Electron Microscope ('SEM')) is desirable for maintaining high yield and low cost for IC chips.

A SEM comprises an scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as secondary electrons and/or backscattered electrons. The detection apparatus captures the secondary electrons and/or backscattered electrons from the target as the target is scanned so that the SEM may create an image of the scanned area of the target. A design of electron-optical tool embodying these SEM features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the secondary electrons from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

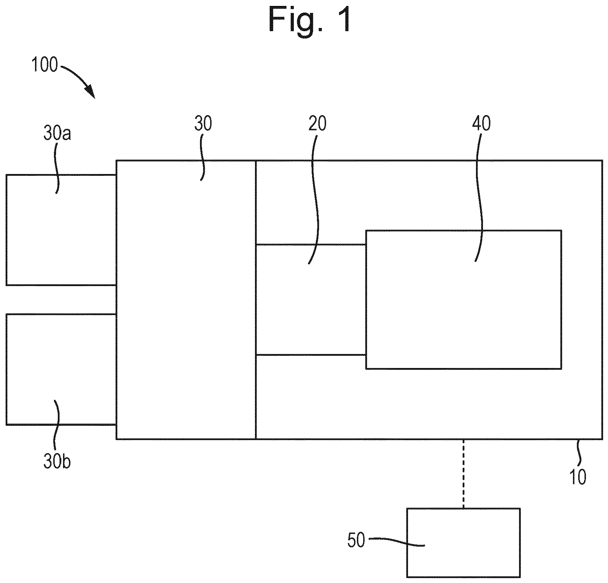

Reference is now made to Figure 1, which is a schematic diagram illustrating an exemplary charged particle beam inspection apparatus 100. The inspection apparatus 100 of Fig. 1 includes a vacuum chamber 10, a load lock chamber 20, an electron-optical column 40 (also known as an electron beam column), an equipment front end module (EFEM) 30 and a controller 50. The electron optical column 40 may be within the vacuum chamber 10.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical column 40 by which it may be inspected. An electron-optical column 40 may comprise either a single beam or a multi-beam electron-optical apparatus.

The controller 50 is electronically connected to the electron-optical column 40. The controller 50 may be a processor (such as a computer) configured to control the charged particle beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection tool, it should be noted that aspects of the disclosure in their broadest sense are not limited to a chamber housing an electron beam column. Rather, it is appreciated that the foregoing principles may also be applied to other tools and other arrangements of apparatus that operate under the second pressure.

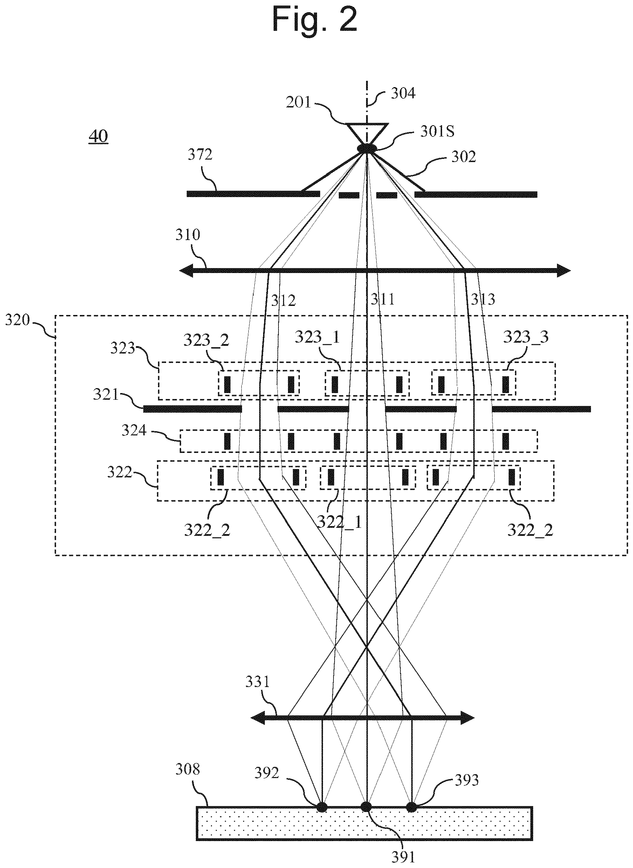

Reference is now made to Figure 2, which is a schematic diagram of an exemplary multi-beam electron-optical column 40 of the inspection apparatus 100 of Figure 1. In an alternative embodiment the inspection apparatus 100 is a single-beam inspection apparatus. The electron-optical column 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical column 40. The source converter 320 (also known as a source conversion unit), described in more detail below, and the objective lens 331 may be the components of a projection apparatus comprised by the electron-optical column 40.

The electron source 201, the beam former array 372, the condenser lens 310, the source converter 320, and the objective lens 331 are aligned with a primary electron-optical axis 304 of the electron-optical column 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical column 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical column 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main column. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical column 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical column 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical column 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical column 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons generally move in an opposite direction compared to the primary electrons, the magnetic force exerted on the secondary electrons and backscattered electrons will no longer cancel the electrostatic force and as a result the secondary electrons and backscattered electrons moving through the beam separator will be deflected away from the electron-optical axis 304.

In an embodiment a secondary column (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary column. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons.

In an embodiment the inspection apparatus 100 comprises a single source.

Any element or collection of elements may be replaceable or field replaceable within the electron-optical column. The one or more electron-optical components in the column, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical column 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

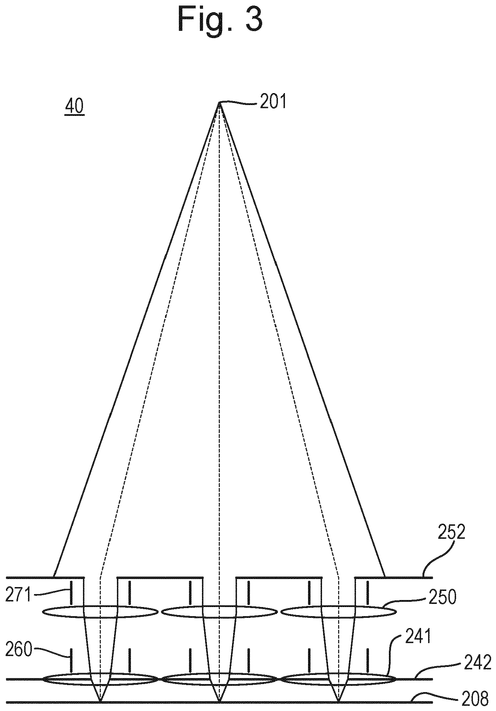

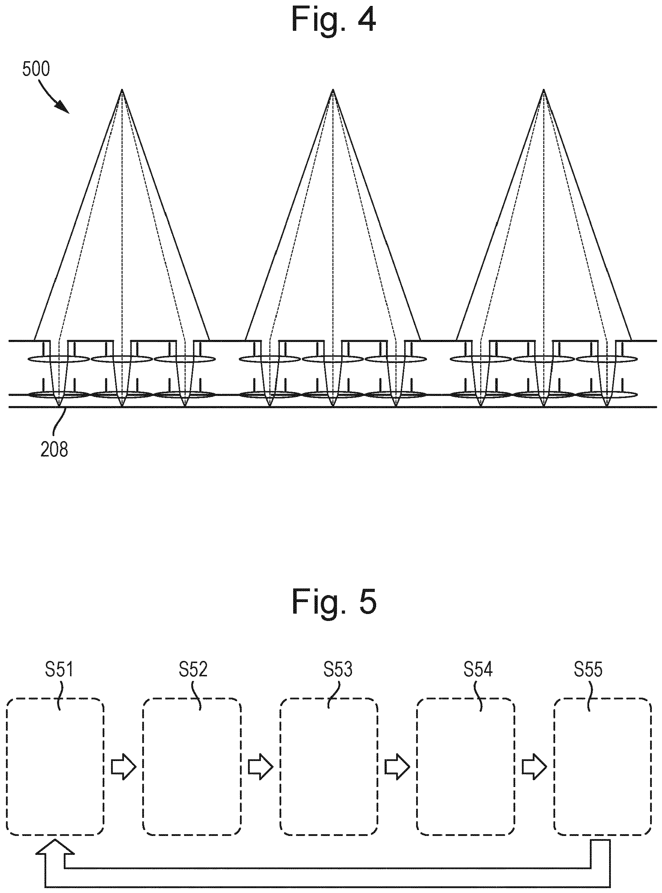

In an embodiment the electron-optical column 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical column 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS or CMOS devices.

Figure 3 is a schematic diagram of another design of exemplary electron-optical system. The electron-optical system may comprise a source 201] and electron-optical column. The electron optical column may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical system is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles detected by an SEM, including secondary and/or backscattered electrons emitted from the sample 208. The detector may be an array providing the surface of the column facing the sample 208, e.g. the bottom surface of the column. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical system array 500 is provided. The array 500 may comprise a plurality of any of the electron-optical systems described herein. Each of the electron-optical systems focuses respective multi-beams simultaneously onto different regions of the same sample. Each electron-optical system may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical systems in the array 500 may be arranged adjacent to each other so as to project the respective multi-beams onto adjacent regions of the sample 208.

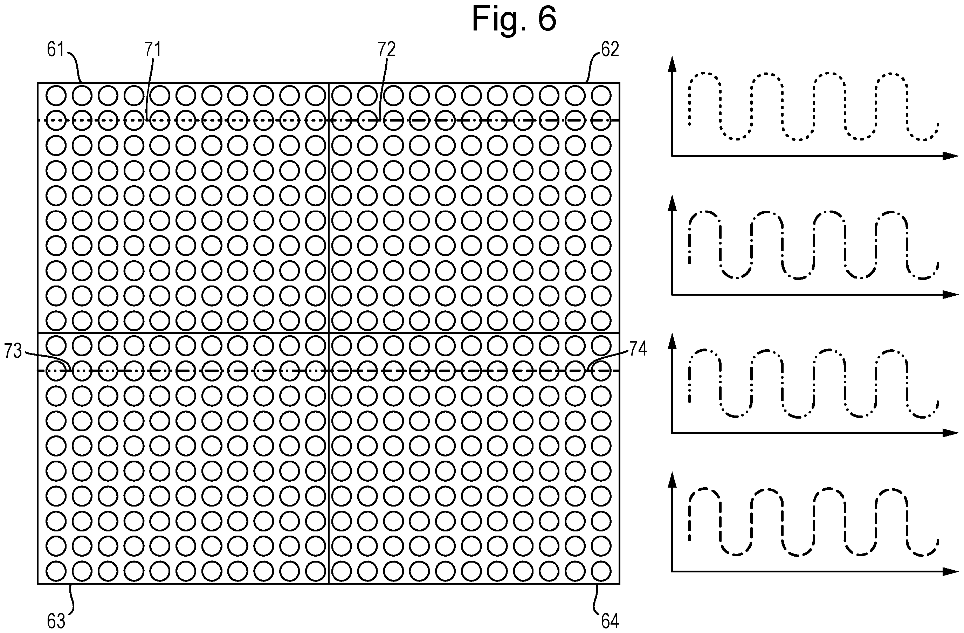

Any number of electron-optical systems may be used in the array 500. Preferably, the number of electron-optical systems is in the range of from 2 (preferably 9) to 200. In an embodiment, the electron-optical systems are arranged in a rectangular array or in a hexagonal array. In other embodiments, the electron-optical systems are provided in an irregular array or in a regular array having a geometry other than rectangular or hexagonal. Each electron-optical system in the array 500 may be configured in any of the ways described herein when referring to a single electron-optical system, for example as described above, especially with respect to the embodiment shown and described in reference to Fig 6. Details of such an arrangement is described in EPA 20184161.6 filed 6 July 2020 which, with respect to how the objective lens is incorporated and adapted for use in the multi-column arrangement is hereby incorporated by reference.

In the example of Figure 4 the array 500 comprises a plurality of electron-optical systems of the type described above with reference to Figure 3. Each of the electron-optical systems in this example thus comprise both a scan-deflector array 260 and a collimator element array 271. As mentioned above, the scan-deflector array 260 and collimator element array 271 are particularly well suited to incorporation into an electron-optical system array 500 because of their spatial compactness, which facilitates positioning of the electron-optical systems close to each other. This arrangement of electron optical column may be preferred over other arrangements that use a magnetic lens as collimator. Magnetic lenses may be challenging to incorporate into an electron-optical column intended for use in a multi-column arrangement.

An alternative design of multi-beam electron optical column may have the same features as described with respect to Figure 3 expect as described below. The alternative design of multi-beam electron optical column may comprise a condenser lens array upbeam of the object lens array arrangement as disclosed in EP application 20158804.3 filed on 21 February 2020 which is hereby incorporated by reference so far as the description of the multi-beam column with a collimator and its components. Such a design does not require the beam shaping limiter array 242 or the upper beam limiter array 252 because a beam limiting aperture array associated with condenser lens array may shape the beamlets of the multi-beam from the beam of the source. The paths of the beamlets diverge away from the condenser lens array. The condenser lens array focuses the generated beamlets to an intermediate focus between the condenser lens array and the objective lens array assembly (i.e. towards the control lens array and the objective lens array). The collimator array maybe at the intermediate foci instead of associated with the objective lens array assembly. The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. An electron-optical system array may have multiple multi-beam columns of this design as described with reference to the multi-beam column of Figure 3 as shown in Figure 4. Such an arrangement is shown and described in EP Application 20158732.6 filed on 21 February 2020 which is hereby incorporated by reference with respect to the multi-column arrangement of a multi-beam tool featuring the design of multi-beam column disclosed with a collimator at an intermediate focus.

A further alternative design of multi-beam tool comprises multiple single beam columns. The single beams generated for the purposes of the invention herein described may be similar or equivalent to a multi-beam generated by a single column. Such a multi-column tool may have one hundred columns each generating a single beam or beamlet. In this further alternative design the single beam columns may have a common vacuum system, each column have a separate vacuum system or groups of columns are assigned different vacuum systems. Each column may have an associated detector.

The electron-optical column 40 may be a component of an inspection (or metro-inspection) tool or part of an e-beam lithography tool. The multi-beam charged particle apparatus may be used in a number of different applications that include electron microscopy in general, not just SEM, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, unless explicitly mentioned. The electron-optical axis 304 may be the same as, or different from, a mechanical axis of the electron-optical column 40.

### Inspection overview

The method and tool of this disclosure enable real-time analysis for physical defect inspection using a multi detector-beam tool comparing a column. For example, a multi-beam tool (i.e. an MBSEM) may be used to enable the immediate defect analysis inside a vacuum, without communication or analysis outside the SEM itself. To aid description of the present invention, the term 'detector-beam' is used in reference to an inspecting beam of an inspection tool which may be in the form a light beam for a bright field inspection tool or an electron beam for an electron beam tool. In a setup consisting of multiple detector-beams, where a number of beams are scanning different areas of the sample, the scans are collected by a detector and converted into an electrical signal. At an instant in time, each beam may form a spot of a certain size on a sample surface. Instead of storing the scanned images, the electrical signals are immediately compared. When all the detector-beams (or a subset of these beams), are scanning corresponding areas of the sample the signal generated by each of the detector-beams is the same or similar. In such a situation the different areas of the sample have nominally identical for example patterns or structures. However, if one of the scanned areas of the sample contains a defect, the signal corresponding to the detector-beam inspecting that defect area is different than the signal(s) corresponding to the other beam(s).

This method may be used to inspect samples such as semiconductor wafers. The comparisons can be made using: within-die inspection or die-to-die inspection. In within-die inspection the detector-beams scan corresponding areas on the same semiconductor die (herein referred to as 'die') with same features, for example an array of contact holes. In die-to-die inspection the signals generated from detector-beams scanning one die are compared to signals generated from detector-beams scanning the corresponding area of another die.

### Inspection method overview

An inspection method for identifying defects in or on a sample, such as a semiconductor wafer, has been developed as shown in Figure 5. The method comprises a scanning step S51 during which detector-beams scan corresponding areas of the sample. Preferably, the corresponding areas of the sample are scanned simultaneously.

The detector-beam scans performed in step S51 are converted into electrical signals which are compared in a comparison step S52. It is intended that the corresponding areas of the sample are areas which have the same feature or pattern. Therefore, it is expected that the received signals will match. Matching of the received signals permits variance between the signals. Such variance is within a predetermined comparison threshold to account for noise and acceptable levels of deviation/mismatch in the signals. For example, a defect may be identified if the amplitude of one current signal deviates from the amplitude of a corresponding signal by more than a predetermined comparison threshold. The comparison threshold is a maximum difference between the amplitude of the signals. The comparison threshold may be determined through experimental data by comparing signals from a sample known to be defect free relative to signals generated on detection of a defect. The signals are calibrated to filter out the signal noise, because there is always some residual signal noise. The filtering of the residual signal noise may be done by removing a characteristic signal noise from the signal from the sample. The characteristic signal noise may be determined by generating a signal from a sample known to be defect free. An acceptable signal noise is determined by the capture to nuisance rate, which may be more than 90 or 95 percent. Preferably, the signals from the sample are compared directly in real-time. With simultaneous scanning and real-time comparison of the signals from corresponding areas, it is possible to determine whether or not the scanned areas of the sample contain a defect without storing and/or transmitting large amounts of data.

Next, in a defect detection step S53, it is determined whether a defect is present in the sample based on the results of the comparison in step S52. A defect may be identified if one signal does not match the other signal(s) within a predetermined comparison threshold for a predetermined number of pixels. If there are only two signals being compared then both of the scanned areas may be determined to be potential defect areas. If there are more than two signals, then in a case where two or more signals match and there is one non-matching signal, it can be determined that the non-matching signal corresponds to data from a scanned area of the sample which contains a defect and is therefore determined to be a defect area. Optionally, the same defect area may be scanned again with the detector-beams being in a position offset from the original scanning position. The detector-beams may be repositioned, for example by repositioning the sample relative to the column. Scanning the same defect area at a different scan path increases the probability that a real defect is encountered and not an arbitrary random event. This may reduce 'nuisance defects' or false positive defect flags. This may be applied, for example when a defect is larger than the spot size. In such a situation multiple scan lines will detect a defect at the same location, indicative of a real defect.

Optionally, an image acquisition step S54 is performed to re-scan any area determined in step S53 to be a defect area or a potential defect area. In the image acquisition step acquired images of the defect area(s) are gathered by re-scanning the defect areas and/or potential defect areas.

Optionally, a defect classification step S55 is performed to identify whether there is a defect in the potential defect area(s) or defect area(s) based on the acquisition image(s) gathered in step S54. In step S55 it is preferable to transmit the acquired images to a separate analysis unit to classify the type of defect based on the acquired images. The image acquisition step S54 and defect classification step S55 may be carried out immediately upon detection of a defect in step S53. Alternatively, steps S54 and S55 may be carried out subsequently at a separate time. Optionally, the rescanning performed to acquire the acquired images in step S54 may be carried out using a different scanning device than that used in step S51. In this way there may be separate apparatus dedicated to acquiring more detailed re-scan acquired images while the inspection tool may be dedicated to the detection of defects to identify the areas to be rescanned. For example, a different inspection tool, configured to capture data for generating higher resolution images than the tool used for the initial defect identification, may be used to perform the more detailed scan. The more detailed scan may take more time to perform that the initial scans. Therefore, the faster tool, which may have lower resolution, may be used for the initial defect detection scans. The more detailed scans may be performed when a defect area is identified. This multi-step process can save time and acquire detailed images of the identified defects. The strategy and tools used may be related to the dimensions of the detected defect. If the size is small a Single beam SEM may be required for the second detailed scan. If the defect is large, an optical tool could be used. So in a set-up, a multi-beam tool may be used for a quick scan of a relatively large area to obtain data at lower resolution. A single beam SEM can then be used to obtain data at higher resolution but is typically slower than other tools. However, the same tool used for the initial scan may be used also for a later scan to acquire more detail

### Inspection tool overview

An inspection tool for identifying defects in the sample comprises a beam generation device which may be in the form of a plurality of beam generation devices configured to generate detector-beams to scan corresponding areas or features of a sample. The inspection tool preferably comprises a scanner configured to simultaneously scan the corresponding areas. The tool therefore may comprise a first beam generation device configured to generate a first detector-beam to scan a first area of a sample and a second beam generation device configured to generate a second detector-beam to scan a second area of the sample. The inspection tool also comprises detectors to generate signals based on the scans of the areas scanned by the detector-beams. The inspection tool may comprise a column comprising the beam generation device and the detectors. The inspection tool therefore comprises a first detector configured to generate a first signal based on the scan of the first area by the first detector-beam and a second detector configured to generate a second signal based on the scan of the second area by the second detector-beam. The inspection tool may comprise more than two beam generation devices, for example the inspection tool may comprise a third beam generation device. The inspection tool may comprise a plurality of detectors each corresponding to one of the beam generation devices to generate signals based on the scans performed by that beam generation device. The inspection tool further comprises a comparison unit configured to compare the signals and to determine whether a defect is present in the sample. The comparison unit may alternatively or additionally compare one or more signals based on scans with reference data, such as synthetic image data. The reference data may be stored in a data file such as in the comparison unit or elsewhere in the tool. Synthetic image data can be generated based on GDS data that represents the nominal pattern that was to be formed on the sample or the mask pattern used in patterning the sample. If the comparison reveals that the signals do not match within a certain comparison threshold, then the comparison unit may be configured to determine that a defect exists in the scanned area corresponding to the mismatched signal. As mentioned the invention may be applied to inspection tools of different types of architectures, for example an electron-beam inspection tool or an optical beam inspection tool. In the multi-beam tool shown in and described with respect to Figure 3, which is depicted with one column, the beam generation device comprises the upper beam aperture array 252. In a multi-column as shown in Figure 4 featuring multi-beam columns of the design shown in Figure 3, the beam generation devices may comprise sources 201; further the beam generators may each comprise a further element in the form of the upper beam aperture arrays 252. In the arrangements of the multi-beam column of Figure 3 and the multi-column of Figure 4, the individual detectors so described may be the elements of the detector arrays. The elements of these detector arrays may detector electrons derived from a corresponding detector-beam or beamlet. In an arrangement the detector array may have detector elements associated with group of the detector-beams.

The comparison unit may be configured to compare first, second and third signals from the first, second and third beam generation devices to determine whether a defect is present. Based on the comparison of the first, second and third signals the comparison unit may determine if a defect is detected. Based on the comparison of the first, second and third signals the comparison unit may determine which of the first, second and third areas is a defect area of the sample. For example, if two of the three signals match each other and one of the signals is mismatched, the comparison unit may determine that the mismatched signal is indicative of a defect. Therefore, the comparison unit may determine that the scanned area corresponding to the mismatched signal is a defect area of the sample.

The comparison unit may decide to rescan a scanned area on detection of a mismatched signals. A signal mismatch indicates detection of the defect. The scanned area may be referred to as a defect area. The comparison unit may be configured to command the beam generation devices to scan a defect area to acquire data for generating an acquired image of the defect area. If there are only two signals being compared, corresponding to the first area and the second area, then the comparison unit may be configured to command the first and second beam generation devices to re-scan the first and second areas, respectively. Alternatively, or in addition to commanding the scanning of the defect area, the comparison unit may be configured to transmit a notification that a defect has been identified. This notification may be used to perform subsequent more detailed inspection of the sample.

The detectors may be configured to transmit any data acquired scanning defect areas to an analysis unit. The analysis unit may be part of the inspection tool. Alternatively or additionally the analysis unit may be a separate device or tool and may be in a different location than the inspection tool. The analysis unit is configured to classify the type of defect based on the acquired images captured by rescanning the defect areas of the sample, where it has been determined that a defect is present in the sample.

The data storage, transmission and processing costs are small because areas of the sample which have no defects are not subject to detailed scans to gather the acquired images and these images are not stored and analyzed for every area of every sample. Instead, the inspection tool determines whether a defect is present in a particular area of the sample and the more detailed scan, and subsequent transmission and/or storage of the acquired image are only performed for areas where it is highly likely that a defect is present in the sample. This more targeted approach allows for faster and more efficient inspection of samples and identification of defects.

### Defect detection by signal comparison

Figures 6 to 8 each illustrate a sample with four corresponding areas in the field of view of four detector-beams, configured to scan four areas 61, 62, 63, 64 of the sample. The scan path of the detector-beams on the four areas are represented by dashed lines 71, 72, 74 and 74. The dashed lines indicate the scanned path over corresponding features in each of the areas. The Figures also show traces/charts of the four corresponding four signals generated from the four detector-beam scans, with the current in the detector plotted against the distance of the scan.

In Figure 6 there are no defects in any of the corresponding scanned areas of the sample. Therefore, in Figure 6 all four of the signals match and therefore the scanned regions of the sample areas are defect free. That is, no defect is detected by the inspection method illustrated in Figure 5.

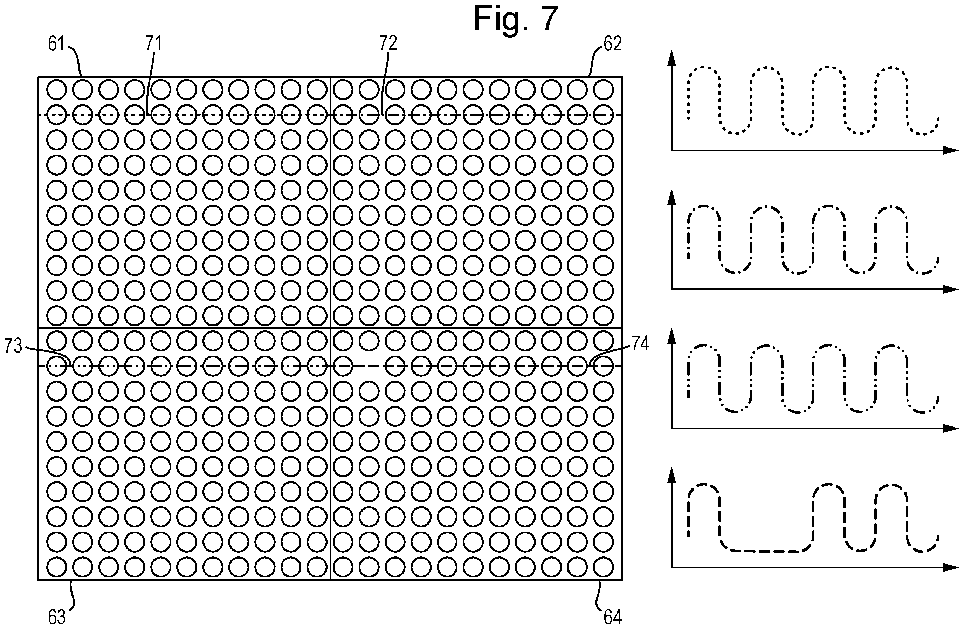

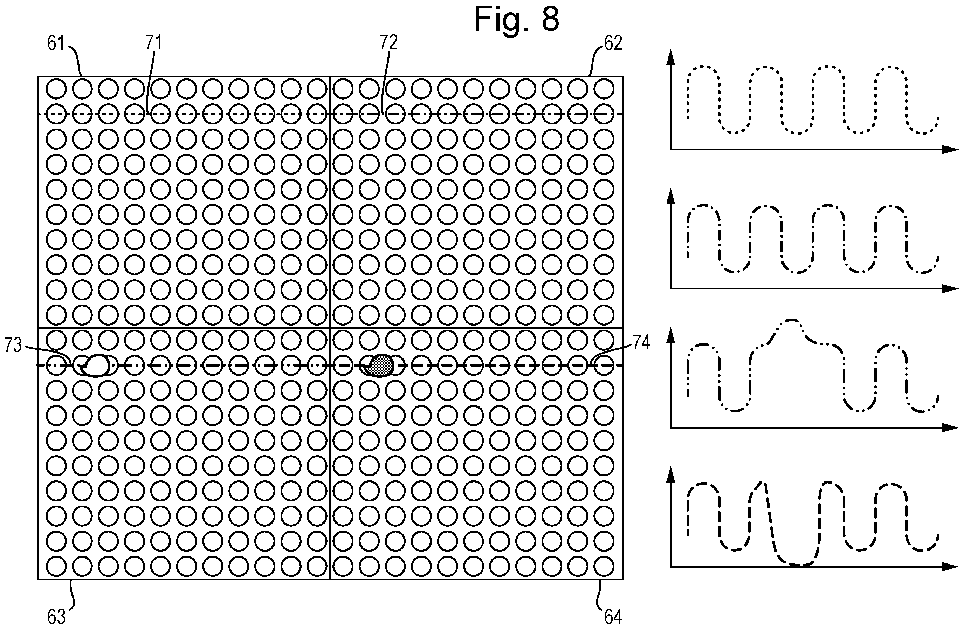

Figures 7 and 8 similarly each show four corresponding areas of a sample, which have been scanned by four detector-beams to generate four signals. However, the lower right scanned areas of the samples in Figure 7, and both the lower left and lower right samples of Figure 8, contain defects.

Figure 7 illustrates an example in which the defect is a missing feature, e.g. a hole, on the sample in the lower right area. This missing hole has resulted in a disruption in the pattern scanned by the detector-beam on path 74 in scanning area 64, which is evident from the fourth signal. The fourth signal does not match the first, second and third signals. Therefore, using the inspection method of Figure 5, the lower right area 64 of the sample would be determined to be a defect area. Thus, this area might be re-scanned to gather data to acquire an image. The image could be analyzed to classify that the defect takes the form of a missing hole. Alternatively, the type of defect may be classified by comparing the mismatched signal with the other signals to determine that the mismatched signal mismatches the other signals. The other signals are similar and so match with each other. Alternatively, the type of defect may be classified by comparing the mismatched signal with a known, expected signal pattern for that area of the sample. The expected signal pattern may take the form of a datafile which is compared with the mismatched signal.

Figure 8 illustrates an example where the defects are unwanted particles on the sample in the lower left and lower right areas. These unwanted particles have resulted in a disruption in the pattern scanned by detector-beams on paths 73 and 74 in areas 63 and 64, which is evident from the third and fourth signals which do not match the first and second. Therefore, using the inspection method of Figure 5, the lower left and lower right areas of the sample, corresponding to areas 63 and 64, would be determined to be defect areas. Thus, these area might be re-scanned to gather acquired images which could be analyzed to classify that the defects take the form of unwanted particles.

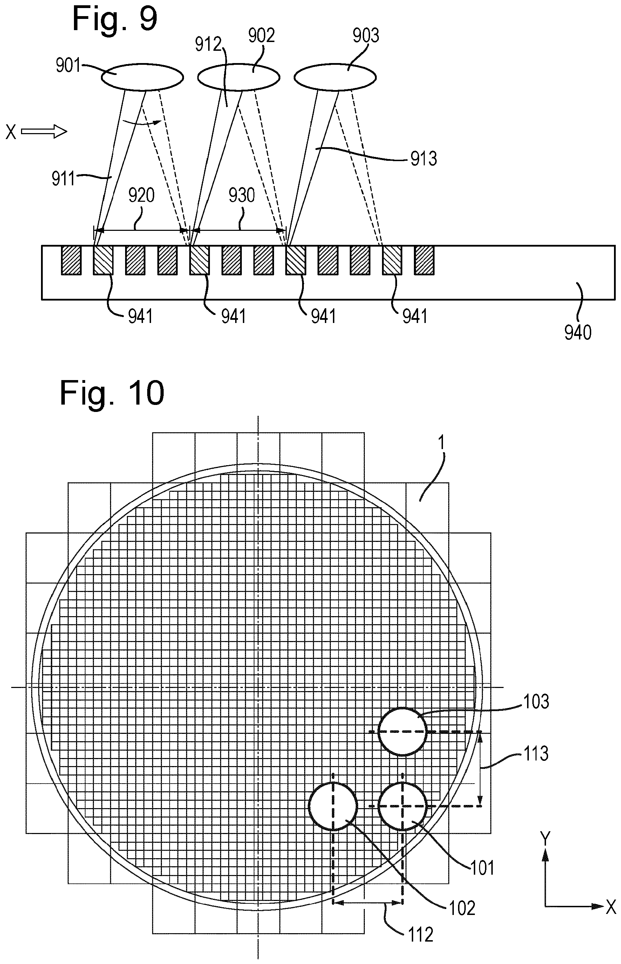

To ease direct comparison of the signals, the beam generation devices are preferably positioned such that each of the detector-beams is incident on the same feature which is repeated in the corresponding areas of the sample being scanned, as illustrated in Figure 9. Figure 9 shows beam generation device 901, 902 903 generating detector-beams 911, 912, 913 to scan the sample 940. A feature 941, such as particular pattern or series of holes, repeats at regular intervals across the sample 940. The detector-beams 911, 912, 913 each scan one of the repeating features 941 in an arbitrary direction X. The feature pitch 920 of the feature 941 is the distance, in the X direction, between a starting position of the feature 941 and the corresponding starting position of the feature 941 on the corresponding area of the sample 940 where the feature 941 is repeated. The feature 941 is scanned by a first detector-beam 911 from a first beam generation device 911 on one area of the sample 940. The corresponding feature 941 is scanned by a second detector-beam 912 generated by a second beam generation device 902. The beam pitch 930 is the distance in a scanning direction, X direction, between the points at which adjacent detector-beams 902, 903 intersect with the sample 940. The beam pitch of the beam generation devices is preferably calibrated such that the beam pitch and the feature pitch do not differ by more than a feature pitch threshold. The feature pitch threshold is a maximum difference between the beam pitch and the feature pitch.

The beam pitch of the detector-beams may be adjusted such that the first detector-beam is aligned to scan the first area and the second detector-beam is aligned to scan the second area at a predetermined beam pitch. In within-die inspection, the first area may correspond to a first feature of a die and the second area may correspond to a second feature of the same die. Alternatively, in die-to-die inspection, the first area may corresponds to a first feature on a first die and the second area may correspond to a second feature on a second die. In the absence of any defects, the two features from the two areas correspond, i.e. are similar, to each other. Preferably the pattern of the features in the first area and the second area are similar if not the same.

In a die-to-die comparison, the beam pitch of the beam generation devices is preferably calibrated such that the beam pitch and the distance between corresponding points on the dies being compared, i.e., a multiple of the die-to-die pitch, differ by, or less than, a die pitch threshold. The die pitch threshold is a maximum difference between the beam pitch and the die pitch.

With each of the beams in, preferably perfect, alignment with the corresponding features, or corresponding parts of features, on the sample, a direct comparison between the signals can be made. For example the signals may be compared by subtracting one signal from another. In this configuration, with a simple subtraction, the difference between the signals can be calculated. In this arrangement, a defect may be determined when a difference between the signals is greater than a predetermined comparison threshold. The comparison may be performed by a comparison unit disposed within a vacuum chamber housing the image generation devices.

If the pitch of the beams does not correspond to the pitch of the features of the sample, there may be some misalignment causing the signals to be offset. In this scenario, a first detector-beam might scan a left side of a first hole in a first scanned area while a second detector-beam scans a right side of the first hole in a second scanned area. Thus, the first signal might be shifted in time with respect to the second signal. In this scenario, the signals should be processed to account for the time shift between the signals before comparing. Such processing may comprise buffering (or storing) one or both signals so that the time difference between the signals can be substantially eliminated. Note that such storing may use timing delay triggers so that the time at which the data is stored for different signals derived from different beams is different, eliminating the time difference in the stored data. After processing of one or bother signals they may be compared to determine whether the signals do or do not match indicating whether or not a defect is present in the scanned area of the sample. Such matching of the signal may be a tolerance range or limit.

Alternatively, or in addition to the comparison of signal amplitude, the signals may be compared in the frequency domain. In the examples shown in Figures 6, 7 and 8, the matching signals have a single frequency, corresponding to the regular pattern of holes in the feature of the sample being scanned. In the presence of a defect, such as a missing contact hole or an unwanted particle in the sample, the signals also have an additional, different frequency, corresponding to the interruption of the regular pattern.

The signals to be compared may generated from a multiple scans, i.e. not from a signal scans. A plurality of scan lines may be gathered and combined to boost the signal prior to the comparison with the other, corresponding, signals. Appropriate signal processing may be applied to extract and combine the signals in phase, for example by using lock-in amplifiers (a type of amplifier that can extract a signal with a known carrier wave from an extremely noisy environment). A reference signal may be provided based on the expected signal for the known pattern being scanned in the scan area of the sample. The reference signal may be based on the mask data of the sample. The mask data may be a reference file which a processor compares with the detected signal.

### Beam pitch adjustment

It is preferable that the beam pitch may be calibrated, or adjusted, to correspond to the feature pitch and/or the die pitch or a multiple thereof. Therefore, the inspection tool may be configured to adjust the beam pitch of the detector-beams within a first beam adjustment threshold The first beam adjustment threshold corresponds to a maximum permissible adjustment to the beam pitch between relevant detector-beams so that the detection beams are aligned with the feature pitch and/or the die pitch or a multiple thereof. The detector-beams generated by the beam generation devices may be operated on by individual beam pitch correctors configured to adjust the beam pitch within the first beam adjustment threshold. The individual beam correctors may be electron-optical or optical active elements in the detector-beam path. The individual beam pitch correctors, in an electron beam arrangement of the multi detector-beam tool may be a manipulator devices as disclosed in WO 2012/148267 A1, which document is incorporated herein by reference in particular in relation to the description of the manipulator devices.

The inspection tool may comprise only one column or may comprise a plurality of columns. There may be a plurality of beam generation devices disposed on the single column. The signals from scans by detector-beams from the beam generation devices may be compared to detected signals from scans by detector-beams from other beam generation devices associated with the same column.

### Multi-column systems

The inspection tool may comprise a plurality of columns. Each column may comprise only one beam generation device. Alternatively, multiple beam generation devices may be associated with each column. The detectors associated with the beam generation devices, from which signals are to be comparted, may each be disposed on different columns. Preferably, each of the detectors of the beam generation devices, from which signals are to be comparted, may be disposed at a corresponding position on the columns. For example, the first beam generation device may be disposed on a first column and the second beam generation device may be disposed on a second column. Preferably, the first beam generation device may be disposed at a first position on the first column and the second beam generation device may be disposed at the corresponding first position on the second column. Applying this architecture to multi-beam tools, a multi-column tool of single electron beam columns may correspond to a multi-column system with a single beam generation device per column. Each column may have a detector which may be in the form of a detector array. A multi-beam column tool of multi-beam columns may correspond to a multi-column system with a multi-beam generation devices per column. Each column may have a detector which may take the form of a detector array. The detector elements of the detector array may correspond to each beamlet of the multi-beam arrangement or groups of the beamlets of the multi-beam array. The signals of the detector elements at similar locations in each detector array may be related to each other, e.g. compared. Thus each column of the multi-column system may have in plan a footprint in which similar features are at similar locations within the footprint. Each column of the multi-column system may be disposed in the same vacuum chamber. Alternatively, each column may be associated with its own vacuum chamber, meaning the multi-column system comprises multiple vacuum chambers.

The inspection tool may comprise two columns, or three columns, or more than three columns. The columns may be configured to be positionable relative to each other, e.g. move relative to each other, such that the first column and the second column may configured to be moved to adjust the beam pitch within second beam adjustment threshold. The second beam adjustment threshold corresponds to a maximum permissible adjustment to the column position between relevant columns so that the detector-beams are aligned with the feature pitch and/or the die pitch or a multiple thereof. The inspection tool may comprise a third beam generation device disposed on a third column configured to move to adjust the beam pitch within the second beam adjustment threshold. Further columns may be provided similarly.

Figure 10 shows a configuration of three columns 101, 102, 103 for die-to-die inspection on a sample 1. The column pitch can be adjusted by movement of the columns. The column pitch between two columns is a distance between similar features in the footprint of the columns. For example, the pitch may be distance between the point of intersection of the optical axis of one column and the sample and the point of intersection of the optical axis of the other column and the sample.

In the configuration of Figure 10, the first, second and third columns 101, 102, 103 are orthogonal to each other. The first, second and third columns are therefore arranged as follows: each column is arranged so that the optical axes of the columns intersect with the sample, for example the plane of the sample. The sample plane may be orthogonal to the optical axes of the columns. The optical axis of the first column intersects the sample at a first point of intersection. The optical axis of the second column intersects the sample at a second point of intersection. The optical axis of the third column intersects the sample at a third point of intersection. The columns are configured such that a first virtual line between the first point of intersection to the second point of intersection is perpendicular to a second virtual line between the third point of intersection and the first virtual line, preferably between the first point of intersection and the second point of intersection. In an arrangement the second virtual line joins the third point of intersection to either first point of intersection or the second point of intersection. The centre points of the first, second and third columns at a common feature, such as their beam generation device's detectors or a final beam directing elements, may be arranged at the vertices of a virtual triangle. The virtual triangle may preferably be a right angled triangle or an isosceles triangle such as an equilateral triangle. The virtual triangle may correspond to a virtual triangle in the surface of the sample and/or the plane of the sample.

In the configuration of Figure 10, the column pitch can be adjusted by movement of the columns in the lateral directions X and Y. The pitches along the X and Y axes (or directions) may be an X-column pitch 112 and a Y-column pitch 113.

The beam pitch may be adjusted, within the second beam adjustment threshold, by movement of the columns in the X and Y directions to adjust the column pitch. Such column to column alignment may be referred to as mechanical alignment. Such alignment can achieve alignment to within 10 micrometers, preferably 1 micrometer. The minimum column pitch is determined by physical column dimensions. This may be the only limiting to the minimum column pitch. The detector-beam pitch within the columns and for fine alignment between corresponding detector-beams in different columns may be adjusted by individual beam pitch correctors. The individual beam correctors are configured to adjust the beam pitch within the first beam adjustment threshold. Such correction of the beams by the individual beam correctors may be referred to as beam alignment, or for an electron beam tool, electron beam alignment. The beam alignment bridges the gap between mechanical column-to-column alignment. For electron beam alignment, the first beam adjustment threshold may be at least within 50 nm, preferably at least within or about 20 nm or less. The remaining misalignment between beams and the resulting signals from the associated detectors may be addressed by other techniques such as buffering the signal or through signal processing, for example on the fly.

One of the columns, such as the first column 101 in Figure 10, may be used as a reference column. The reference column may be positioned first and the other columns may be configured to be positionable relative to the reference column.

Initial calibration of the alignment of the columns may be performed relative to the reference column, for example. The beam generation unit or units associated with the reference column may be used to generate detector-beams that are scanned over an area of the sample to acquire data to generate an alignment image or images. The other columns 102, 103 may be used similarly to acquire corresponding alignment images. These images may be compared, for example by overlaying the images. Adjustments to the column pitch and beam pitch may be performed until an acceptable alignment is achieved between the columns. An acceptable alignment is achieved when the representative images correspond with a tolerance. For example, the reference column 101 may remain in place while the positions of the other columns 102, 102 may be changed relative to the reference column, for example in the X and/or Y direction, to improve the match of the alignment images. Optionally, beam pitch correction may also be applied to improve the alignment in the respective columns between corresponding detector-beams when incident on the sample.

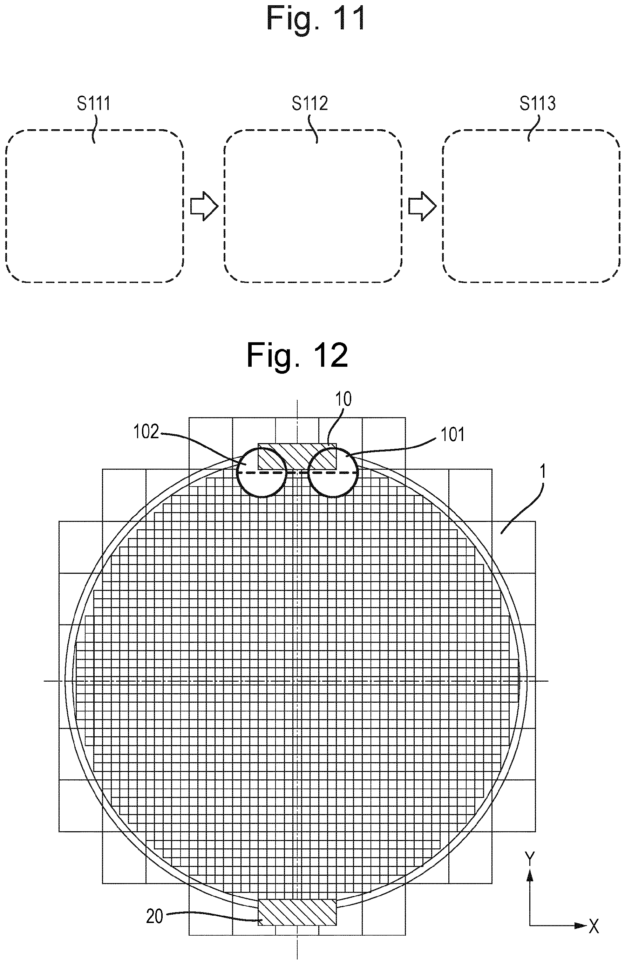

As shown in Figure 11, if the sample is a semiconductor wafer, in a first pass step S111 the inspection tool comprising three or more columns, which may each comprise one beam generation device or multiple beam generation devices, scans the full wafer in a die-to-die inspection. Defects will be detected when any two areas are simultaneously scanned and a mismatch in the resulting signals is identified. Because there are three or more columns, in a defect determination step S112 it can be determined which scanned area contains the defect. This is because there is likely to be two matching signals, from the two columns which have scanned areas not including a defect, and one mismatched signal, from the column which has scanned the defect area where the sample has a defect. Thus, the defect areas of the wafer are identified. In a second pass step S113 the columns pass over the wafer again. In the second pass S113 the identified defect areas are scanned to acquire acquisition images which may be used to classify the defects; no other sample areas are rescanned.

Figure 12 shows that, in a two column configuration, the first and second columns 101 and 102 are disposed such that corresponding beam generation devices are unable to simultaneously scan area 10 or area 20 at the edge of the sample. How large these areas 10, 20 are depends on the column pitch. The two column configuration has the benefits of simplified construction and connectivity requirements. However the configuration has the drawback that some inaccessible sections (such as areas 10 and 20 in Figure 12) cannot be compared in real time. Such an inaccessible section may require an additional pass of scanning to gather sufficient data, i.e. to generate images for defect assessment. That is to determine whether or not there is a defect present in these inaccessible sections of the sample, e.g. areas 10, 20 at the edge of the sample.

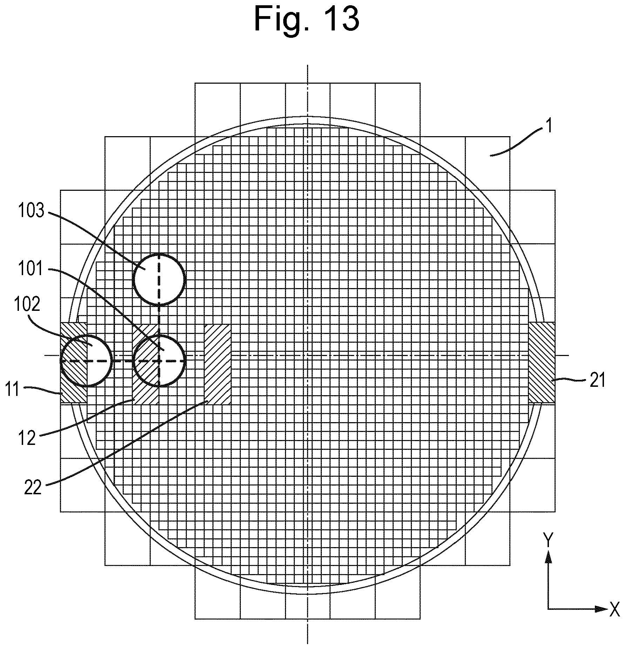

Figure 13 shows that, in a three column configuration, all three columns 101, 102, 103 are disposed such that corresponding beam generation devices disposed on each column are able to scan an area of the sample. The first, second and third columns 101, 102, 103 are configured to be positionable relative to the sample such that any area of the sample is disposed in a scanning range of the detector-beams generated by beam generation devices on at least two of the columns. The first, second and third columns 101, 102, 103 are therefore arranged such that corresponding beam generation devices disposed on at least two of the first, second and third columns are able to scan any given area of the sample. When using the three column configuration, all parts of the sample can be scanned in a single pass, meaning that any die in any part of the sample scanned by one of the columns can be compared by at least one another die scanned by another columns. For example, the areas at the edge of the sample 11, 21 can be simultaneously scanned by two of the three columns, whereas inner areas of the sample, such as the inner areas 12, 22, can be simultaneously scanned by all three columns. This means that a full definitive list of defects is available after only two passes of the columns over the sample, as illustrated by Figure 11.

With the three column system, the benefit is that the entire sample may be inspected in one pass of the columns scanning over the sample. Therefore, all of the defect areas can be readily identified and there is no need to gather acquired images on any areas which have not been identified as defect areas, thus reducing data storage and analysis time and cost.

The inspection tool may be an optical inspection tool. The optical inspection tool may comprise an illumination source, a set of optics, a moveable stage and a detector assembly. A column of the optical inspection tool may comprise at least a set of optics and a detector assembly. The illumination source may emit visible, ultraviolet, deep ultraviolet and/or vacuum ultraviolet radiation. The set of optics is configured to direct and/or focus light from the illumination source onto the surface of the sample. For example, the set of optics may include, but is not limited to, an objective lens for focusing light onto the surface of the sample. With movement of the sample on the moveable stage with respect to the set of optics, the optical inspection tool may scan a beam of radiation over the sample surface. The set of optics may include one or more additional optical components (e.g., lenses or mirrors) for collecting light reflected or scattered from sample. The set of optics may then direct the collected light from the surface of the sample to the detector of the detector assembly. The set of optics may include any number and type of optical elements known in the art for illuminating the surface sample and collecting light from the surface of the sample, such as, but not limited to, mirrors, lenses, and/or beam splitters.

In the optical inspection tool, the beam generation devices may comprise the illumination source and the set of optics. The beam generation devices may therefore generate optical detector-beams for scanning the sample. Light of the detector-beams which is reflected from the sample may then be detected by the detector array to generate signal data. The detector may function as described above with respect to the inspection tool. By comparing the signal data as described previously, any defects on the sample may be detected.

Embodiments of the invention are set out in the following numbered clauses:
Clause 1: An inspection tool for identifying defects in a sample, comprising: a first beam generation device configured to generate a first detector-beam along a first detector-beam path to scan a first area of a sample; a second beam generation device configured to generate a second detector-beam along a first detector-beam path to scan a second area of the sample; a first detector configured to generate a first signal based on the scan of the first area by the first detector-beam; a second detector configured to generate a second signal based on the scan of the second area by the second detector-beam; and a comparison unit configured to compare the first and second signals and to determine whether a defect is present in the sample.
Clause 2: The inspection tool according to clause 1, wherein the comparison unit is configured to compare the first and second signals directly in real-time.
Clause 3:. The inspection tool according to either of clauses 1 and 2, further comprising a scanner configured to scan simultaneously the first and second areas with the first and second detector-beams respectively.
Clause 4: The inspection tool according to any one of clauses 1 to 3, wherein upon determination by the comparison unit of a defect, one of the first or second areas is determined as a defect area, the comparison unit is configured to command the beam generation devices to generate a detector-beam so as to re-scan the defect area to acquire data for generating images of the defect area.
Clause 5: The inspection tool according to clause 4, wherein the detectors are configured to transmit the acquired data to an analysis unit configured to classify the type of defect based on the acquired data.
Clause 6:. The inspection tool according to any one of clauses 1 to 5, wherein the beam generation devices are configured to generate detector-beams as electron beams.
Clause 7:. The inspection tool according to any one of clauses 1 to 6, wherein the inspection tool is configured to adjust the beam pitch of the detector-beams within a first beam adjustment threshold.
Clause 8:. The inspection tool according to clause 7, wherein the inspection tool comprises corrector arrays, preferably individual beam pitch correctors, configured to adjust the beam pitch within the first beam adjustment threshold.
Clause 9: The inspection tool according to any one of clauses 1 to 8, wherein the beam generation devices are associated with the same column.
Clause 10: The inspection tool according to any one of clauses 1 to 8, wherein the first beam generation device is associated with a first column and the second beam generation device is associated with a second column.
Clause 11::. The inspection tool according to clause 10, wherein the first column and the second column are configured to be mutually positionable to adjust the beam pitch within a second beam adjustment threshold.
Clause 12:. The inspection tool according to clause 11, further comprising: a third beam generation device configured to generate a third detector-beam to scan a third area wherein the third beam generation device is associated with a third column configured to move to adjust the beam pitch within the second beam adjustment threshold.
Clause 13:. The inspection tool according to clause 11, wherein centre points of common elements in the first, second and third columns are arranged at vertices of a virtual triangle.
Clause 14:. The inspection tool according to any one of clauses 11 to 13, wherein the first, second and third columns are configured to be positionable relative to the sample such that any area of the sample is disposed in a scanning range of the detector-beams generated by beam generation devices on at least two of the columns.
Clause 15: The inspection tool according to any one of clauses 12 to 14, wherein the comparison unit is configured to: compare the first, second and third signals; determine whether a defect is present; and if a defect is detected, determine which of the first, second and third areas is a defect area of the sample based on the comparison of the first, second and third signals.
Clause 16: The inspection tool according to any one of clauses 9 to 15, further comprising multiple beam generation devices disposed in each column.
Clause 17: The inspection tool according to either of clauses 15 and 16, wherein the comparison unit is configured upon detection of a defect to command the column corresponding to the defect area to re-scan the defect area to acquire data for generating images of the defect area.
Clause 18: The inspection tool according to clause 17, wherein the detector corresponding to the defect area is configured to transmit the acquired data to an analysis unit configured to classify the type of defect based on the acquired image.
Clause 19: The inspection tool according to any one of clauses 1 to 18, wherein the comparison unit is configured to compare the signals and to determine that a defect is present in the sample if the difference between the signals is above a comparison threshold.
Clause 20:. An inspection method for identifying defects in a sample, the method comprising: scanning a first area of a sample with a first detector-beam and scanning a second area of the sample with a second detector-beam; receiving first and second signals that are derived from the first and second detector-beams; comparing the first and second signals; and determining whether a defect is present in the sample.
Clause 21: The inspection method according to clause 20, wherein the first and second signals are compared directly in real-time.
Clause 22:. The inspection method according to either of clauses 20 and 21, wherein the first and second detector-beams simultaneously scan the first and second areas respectively.
Clause 23:. The inspection method according to any one of clauses 20 to 22, wherein upon determination of a defect, one of the first or second areas is determined as a defect area; a detector-beam is generated; and the defect area is re-scanned to acquire data for generating images of the defect area.
Clause 24 The inspection method according to any one of clauses 19 to 23, wherein the acquired data is transmitted to an analysis unit and the type of defect is classified based on the acquired data.
Clause 25: The inspection method according to any one of clauses 19 to 24, wherein the detector-beams are generated as electron beams.
Clause 26: The inspection method according to any one of clauses 19 to 25, wherein the beam pitch of the detector-beams is adjusted within a first beam adjustment threshold.
Clause 27: The inspection method according to clause 26, wherein the beam pitch of the detector-beams is adjusted by a beam pitch corrector to be within a first beam adjustment threshold.
Clause 28: The inspection method according to any one of clauses 19 to 27, wherein the first detector-beam is associated with a first column and the second detector-beam is associated with a second column.
Clause 29: The inspection method according to clause 28, wherein the first column and the second column are mutually positioned to adjust the beam pitch within a second beam adjustment threshold.
Clause 30: The inspection method according to either of clauses 28 and 29, wherein a third detector-beam associated with a third column is generated to scan a third area of the sample; the third column is positioned to adjust the second beam pitch within the second beam adjustment threshold; and a third signal derived from the third detector-beams is received.
Clause 31: The inspection method according to clause 30, wherein the first, second and third signals are compared; it is determined whether a defect is present; and if a defect is present, it is determined which of the first, second and third areas is the defect area of the sample based on the comparison of the first, second and third signals.
Clause 32: The inspection method according to clause 31, wherein, upon detection of a defect, the column corresponding to the defect area re-scans the defect area and acquires data for generating images of the defect area.
Clause 33: The inspection method according to any one of clauses 19 to 32, comprising adjusting the beam pitch of the first and second detector-beams such that the first detector-beam is aligned to scan the first area and the second detector-beam is aligned to scan the second area at a predetermined beam pitch.
Clause 34: The inspection method according to any one of clauses19 to 33, wherein first area corresponds to a first feature of a first semiconductor die and the second area corresponds to a second feature on the first semiconductor die corresponding to the first feature of the first semiconductor die.
Clause 35:. The inspection method according to any one of clauses 19 to 33, wherein the first area corresponds to a first feature on a first semiconductor die and the second area corresponds to a second feature on a second semiconductor die corresponding to the first feature of the first semiconductor die.
Clause 36: An electron-optical tool configured to project a plurality of multi-electron beams towards a sample, the tool configured to identify defects in a sample, comprising: electron-optical columns configured to project corresponding multi-electron beams towards a sample; detector arrays configured corresponding to respective electron-optical columns and configured to generate respective signals on detection of secondary electrons generated by interaction of the respective multi-electron beams with the sample; and a comparator configured to compare signals generated in the detector arrays and to determine whether a defect is present in the sample.
Clause 37: The electron-optical tool of clause 36, wherein the compared signals derive from a beam located at the same position in the array of at least two of the electron-optical columns.
Clause 38: The electron-optical tool of either of clauses 36 and 37, wherein the comparator compares signals direct from the detector arrays.
Clause 39: The electron-optical tool of any one of clauses 36 to 38, wherein the comparator is within a vacuum chamber comprising the electron-optical columns.
Clause 40: The electron-optical tool of any one of clauses 35 to 39, wherein the electron-optical columns are configured to be positionable with respect to each other so as to adjust the relative displacement between regions of the sample associated with the electron-optical columns.
Clause 41: The electron-optical tool of any one of clauses 36 to 40, wherein the electron-optical columns are configured to have adjustable pitch with respect to each other.
Clause 42:. The electron-optical tool of any one of clauses 36 to 41, wherein the pitch the electron-optical columns corresponds to a multiple of the displacement between adjacent fields or dies on the sample.
Clause 43:. The electron-optical tool of any one of clauses 36 to 42, wherein the detector array is configured to have a detector element associated with each beam in the multi-beam array.
Clause 44: The electron-optical tool of any one of clauses 36 to 43, wherein the detector arrays faces the sample.
Clause 45: The electron-optical tool of any one of clauses 36 to 44, wherein the detector arrays define a surface of each multi-beam column closest to the sample
Clause 46: The electron-optical tool of any one of clauses 36 to 45, wherein each column comprises a corrector array configured to adjust the positioning of the beams of the multi-electron beam with respect to each other.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An inspection tool for identifying defects in a sample, comprising:
a first beam generation device configured to generate a first detector-beam along a first detector-beam path to scan a first area of a sample;
a second beam generation device configured to generate a second detector-beam along a first detector-beam path to scan a second area of the sample;
a first detector configured to generate a first signal based on the scan of the first area by the first detector-beam;
a second detector configured to generate a second signal based on the scan of the second area by the second detector-beam; and
a comparison unit configured to compare the first and second signals and to determine whether a defect is present in the sample.

2. The inspection tool according to claim 1, wherein the comparison unit is configured to compare the first and second signals directly in real-time.

3. The inspection tool according to either of claims 1 and 2, further comprising a scanner configured to scan simultaneously the first and second areas with the first and second detector-beams respectively.

4. The inspection tool according to any one of claims 1 to 3, wherein upon determination by the comparison unit of a defect, one of the first or second areas is determined as a defect area, the comparison unit is configured to command the beam generation devices to generate a detector-beam so as to re-scan the defect area to acquire data for generating images of the defect area.

5. The inspection tool according to claim 4, wherein the detectors are configured to transmit the acquired data to an analysis unit configured to classify the type of defect based on the acquired data.

6. The inspection tool according to any one of claims 1 to 5, wherein the beam generation devices are configured to generate detector-beams as electron beams.

7. The inspection tool according to any one of claims 1 to 6, wherein the inspection tool is configured to adjust the beam pitch of the detector-beams within a first beam adjustment threshold.

8. The inspection tool according to claim 7, wherein the inspection tool comprises corrector arrays, preferably individual beam pitch correctors, configured to adjust the beam pitch within the first beam adjustment threshold.

9. The inspection tool according to any one of claims 1 to 8, wherein the beam generation devices are associated with the same column.

10. The inspection tool according to any one of claims 1 to 8, wherein
the first beam generation device is associated with a first column and the second beam generation device is associated with a second column.

11. The inspection tool according to claim 10, wherein the first column and the second column are configured to be mutually positionable to adjust the beam pitch within a second beam adjustment threshold.

12. The inspection tool according to claim 11, further comprising
a third beam generation device configured to generate a third detector-beam to scan a third area;
wherein the third beam generation device is associated with a third column configured to move to adjust the beam pitch within the second beam adjustment threshold.

13. The inspection tool according to any one of claim 12, wherein
the comparison unit is configured to
compare the first, second and third signals,
determine whether a defect is present, and
if a defect is detected, determine which of the first, second and third areas is a defect area of the sample based on the comparison of the first, second and third signals.

14. The inspection tool according to any one of claims 1 to 13, wherein the comparison unit is configured to compare the signals and to determine that a defect is present in the sample if the difference between the signals is above a comparison threshold.

15. An inspection method for identifying defects in a sample, the method comprising:
scanning a first area of a sample with a first detector-beam and scanning a second area of the sample with a second detector-beam;
receiving first and second signals that are derived from the first and second detector-beams;
comparing the first and second signals; and
determining whether a defect is present in the sample
